# EUROPEAN PATENT APPLICATION

(11) **EP 4 517 817 A2**
(43) Date of publication of application: **05.03.2025**
(21) Application number: 24196264.6
(22) Date of filing: 23.08.2024
(51) Int. Cl.: H01L 23/48, H01L 25/065

(54) **SEMICONDUCTOR DEVICES AND SEMICONDUCTOR PACKAGES INCLUDING THE SAME**

(30) Priority: 04.09.2023 KR 20230116847
(71) Applicant: Samsung Electronics Co., Ltd., Gyeonggi-do, 16677 (KR)
(72) Inventor: SONG, Minjun, 16677 Suwon-si (KR); LEE, Jongmin, 16677 Suwon-si (KR); SHIN, Joongwon, 16677 Suwon-si (KR)
(74) Representative: Marks & Clerk LLP

(57) **Abstract**

A semiconductor device includes an interconnection region including lower interconnections on a device region; an insulating structure on the interconnection region; lower conductive patterns in the insulating structure; a first conductive via electrically connecting the lower conductive patterns to the lower interconnections; upper conductive patterns on the insulating structure; and second conductive vias in the insulating structure and electrically connecting the upper conductive patterns to the lower conductive patterns. The second conductive vias include a second metal layer and a second barrier layer, and the upper conductive patterns include a third barrier layer extending from the second barrier layer and on a portion of an upper surface of the insulating structure; a third metal layer on the third barrier layer and extending from the second metal layer; an upper metal layer on the third metal layer; and an upper anti-reflective layer on the upper metal layer.

## Description

### FIELD

Example embodiments of the present disclosure relate to a semiconductor device and a semiconductor package including the same.

### BACKGROUND

As demand for high performance, speed, and/or multifunctionality of a semiconductor device have increased, integration density of a semiconductor device has also increased. In manufacturing a semiconductor device to provide high integration density, it may be necessary to implement fine patterns, that is, patterns having a fine width or a fine spacing. Also, high integration density of semiconductor devices mounted on a semiconductor package may be necessary.

### SUMMARY

According to an example embodiment of the present disclosure, a semiconductor device includes a semiconductor substrate; a device region on the semiconductor substrate; an interconnection region including a lower interconnection on the device region; an insulating structure on the interconnection region; lower conductive patterns in the insulating structure; a first conductive via electrically connecting at least one of the lower conductive patterns to the lower interconnection of the interconnection region; upper conductive patterns on the insulating structure; and second conductive vias in the insulating structure and electrically connecting the upper conductive patterns to the at least one of the lower conductive patterns, wherein the first conductive via includes a first metal layer and a first barrier layer on a lower surface and a side surface of the first metal layer, wherein the second conductive vias respectively include a second metal layer in the insulating structure and a second barrier layer on a lower surface and a side surface of the second metal layer, and wherein the upper conductive patterns respectively include a third barrier layer extending from the second barrier layer and on a portion of an upper surface of the insulating structure opposite the substrate; a third metal layer on the third barrier layer and the second metal layer and extending from the second metal layer; an upper metal layer on the third metal layer; and an upper anti-reflective layer on the upper metal layer.

According to an example embodiment of the present disclosure, a semiconductor package includes a plurality of semiconductor devices sequentially stacked on a buffer chip; adhesive layers between the plurality of semiconductor devices; and an encapsulant on the buffer chip and the plurality of semiconductor devices, wherein the semiconductor devices respectively include an insulating structure on a semiconductor substrate; a via pad below the semiconductor substrate; a through-electrode electrically connected to the via pad and penetrating the semiconductor substrate; lower conductive patterns in the insulating structure; first conductive vias on lower surfaces of the lower conductive patterns; upper conductive patterns on the insulating structure; second conductive vias in the insulating structure and electrically connecting the upper conductive patterns to at least one of the lower conductive patterns; and a connection pad electrically connected to one of the upper conductive patterns, wherein the first conductive vias respectively include a first metal layer and a first barrier layer on a lower surface and a side surface of the first metal layer, wherein the second conductive vias respectively include a second metal layer in the insulating structure and a second barrier layer on a lower surface and a side surface of the second metal layer, wherein the upper conductive patterns respectively include a third barrier layer extending from the second barrier layer and on a portion of an upper surface of the insulating structure; a third metal layer on the third barrier layer and the second metal layer and extending from the second metal layer; an upper metal layer on the third metal layer; and an upper anti-reflective layer on the upper metal layer.

According to an example embodiment of the present disclosure, a semiconductor device includes an insulating structure on a semiconductor substrate; lower conductive patterns in the insulating structure; first conductive vias on lower surfaces of the lower conductive patterns; an upper conductive pattern on the insulating structure; and second conductive vias in the insulating structure and electrically connecting the upper conductive pattern to the lower conductive patterns, wherein the first conductive vias respectively include a first metal layer and a first barrier layer on a lower surface and a side surface of the first metal layer, wherein the second conductive vias respectively include a second metal layer in the insulating structure and a second barrier layer on a lower surface and a side surface of the second metal layer, and wherein the upper conductive pattern includes a first conductive layer extending from the second conductive vias; a second conductive layer on the first conductive layer; and a third conductive layer on the second conductive layer.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a plan view diagram illustrating a semiconductor device according to an example embodiment of the present disclosure;
FIG. 2 is an enlarged plan view diagram illustrating a portion of the semiconductor device illustrated in FIG. 1 according to an example embodiment of the present disclosure;
FIG. 3A is a cross-sectional diagram illustrating a semiconductor device according to an example embodiment of the present disclosure;
FIG. 3B is an enlarged cross-sectional diagram illustrating a portion of a semiconductor device according to an example embodiment of the present disclosure;
FIG. 3C is a plan view diagram illustrating a semiconductor device according to an example embodiment of the present disclosure;
FIGS. 4, 5, 6, 7, 8, and 9 are enlarged cross-sectional diagrams illustrating a portion of a semiconductor device according to example embodiments of the present disclosure;
FIG. 10 is a cross-sectional diagram illustrating a semiconductor device according to an example embodiment of the present disclosure;
FIG. 11A is a cross-sectional diagram illustrating a semiconductor package including a semiconductor device according to an example embodiment of the present disclosure;
FIGS. 11B is an enlarged cross-sectional diagram illustrating a portion of the semiconductor package illustrated in FIG. 11A according to example embodiments of the present disclosure;
FIG. 12 is a cross-sectional diagram illustrating a semiconductor package including a semiconductor device according to an example embodiment of the present disclosure; and
FIGS. 13, 14A, 14B, 15, 16A, 16B, 17, 18, 19, 20, 21, 22, 23, 24, 25, and 26 are cross-sectional diagrams and enlarged cross-sectional diagrams illustrating fabrication processes of a method of manufacturing a semiconductor device sequentially on a semiconductor substrate, according to an example embodiment of the present disclosure.

### DETAILED DESCRIPTION OF EMBODIMENTS

Hereinafter, embodiments of the present disclosure will be described as follows with reference to the accompanying drawings. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. The term "connected" may be used herein to refer to a physical and/or electrical connection. When components or layers are referred to herein as "directly" on, or "in direct contact" or "directly connected," no intervening components or layers are present. Likewise, when components are "immediately" adjacent to one another, no intervening components may be present.

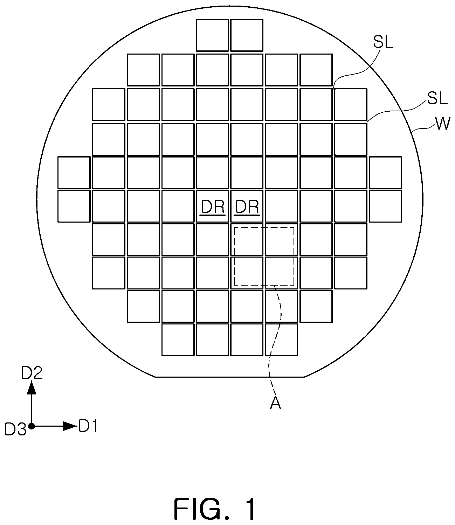

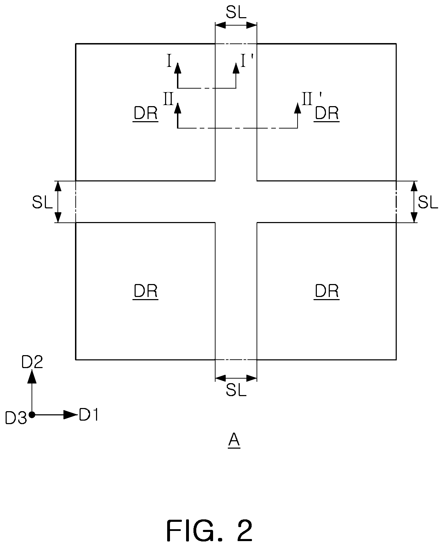

FIG. 1 is a plan view diagram illustrating a semiconductor device according to an example embodiment. FIG. 2 is an enlarged plan view diagram illustrating a portion of the semiconductor device illustrated in FIG. 1 according to an example embodiment corresponding to region "A" in FIG. 1.

Referring to FIGS. 1 and 2, the semiconductor substrate or wafer W may include device regions DR and a scribe line region SL between the device regions DR. The scribe line regions SL may extend in the first horizontal direction D1 and the second horizontal direction D2 intersecting the first horizontal direction D1 e.g. wherein the second horizontal direction D2 is different, and optionally orthogonal, to the first horizontal direction D1. The device regions DR may be provided in the first horizontal direction D1 and second horizontal direction D2, and may be surrounded by scribe line regions SL. By a dicing process to be described later, the device region DR may be isolated along the scribe line region SL and may form the semiconductor device 100. The terms "surrounding" or "covering" or "filling" as may be used herein may not require completely surrounding or covering or filling the described elements or layers, but may, for example, refer to partially surrounding or covering or filling the described elements or layers.

In an example embodiment, in the device region DR, a volatile memory device such as a dynamic random access memory (DRAM) or a static random access memory (SRAM), or a non-volatile memory device such as a phase-change random access memory (PRAM), a magnetoresistive random access memory (MRAM), a ferroelectric random access memory (FeRAM), or a resistive random access memory (RRAM) may be provided. In an example embodiment, in the device region DR, a logic device such as a microprocessor, an analog device, or a digital signal processor may be provided.

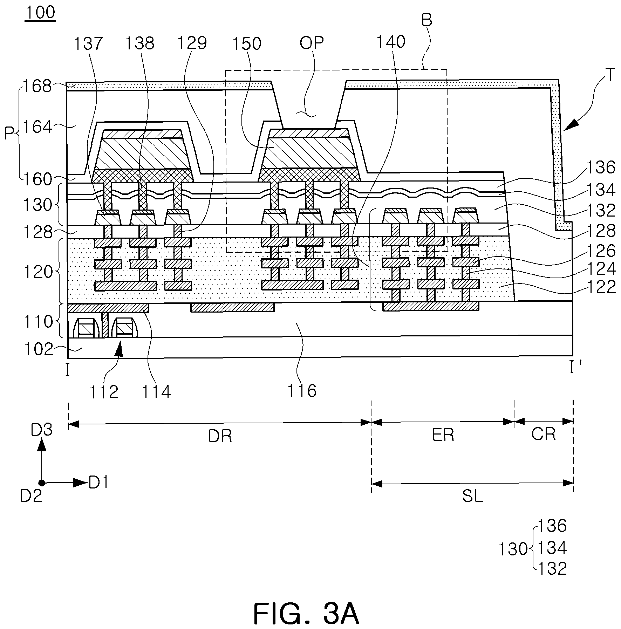

FIG. 3A is a cross-sectional diagram illustrating a semiconductor device according to an example embodiment, taken along line I-I' in FIG. 2.

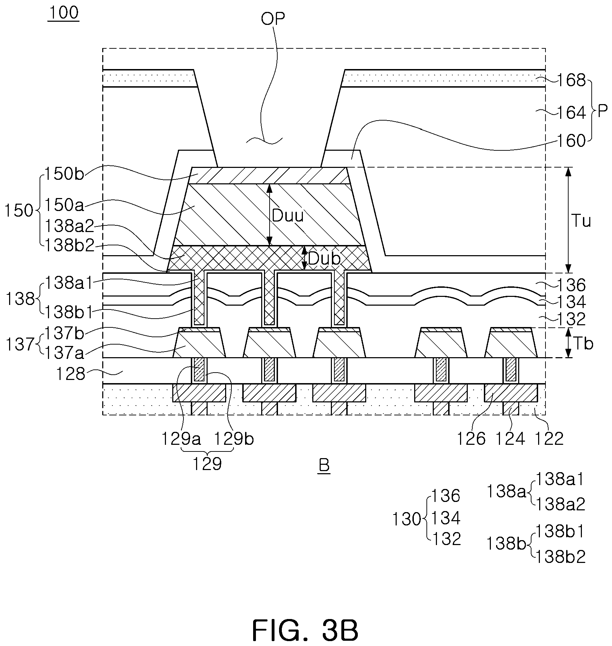

FIG. 3B is an enlarged diagram illustrating a portion of a semiconductor device according to an example embodiment corresponding to region "B" in FIG. 3A.

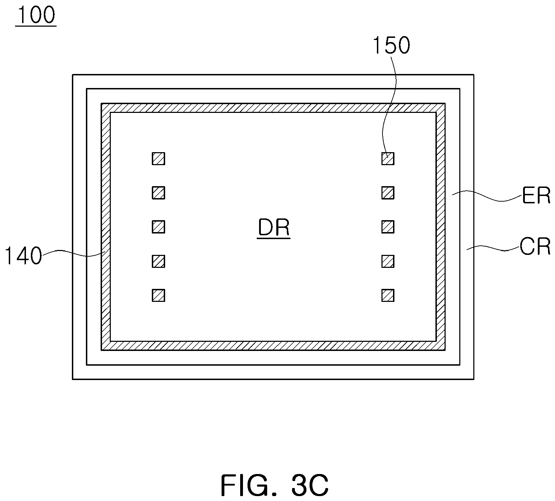

FIG. 3C is a plan view diagram illustrating a semiconductor device according to an example embodiment.

Referring to FIGS. 3A to 3C, a semiconductor device 100 may include a semiconductor substrate 102, a device region 110 on the semiconductor substrate 102, an interconnection region 120 on the device region 110, an insulating structure 130 on the interconnection region 120, an interlayer insulating layer 128 between the interconnection region 120 and the insulating structure 130, lower conductive patterns 137 disposed in the insulating structure 130, a first conductive via 129 connecting the lower conductive patterns 137 to the interconnection region 120, upper conductive patterns 150 on the insulating structure 130, and a second conductive via 138 connecting the upper conductive patterns 150 to the lower conductive patterns 137. The semiconductor device 100 may further include a passivation structure P including a protective layer 160, a first passivation layer 164 on the protective layer 160, and a second passivation layer 168 on the first passivation layer 164.

The semiconductor substrate 102 may include device regions DR and a scribe line region SL between the device regions DR. The scribe line region SL may include edge regions ER and a cutting region CR between the edge regions ER. The edge region ER may surround the device region DR. The cutting region CR may refer to a portion isolated during the dicing process described later. The semiconductor substrate 102 may include a semiconductor material. For example, the semiconductor substrate 102 may be a silicon substrate, a germanium substrate, a silicon germanium substrate, or a silicon on insulator (SOI) substrate. The semiconductor substrate 102 may include a semiconductor material such as a group IV semiconductor, a group III-V compound semiconductor, or a group II-VI compound semiconductor.

The device region 110 may include integrated circuit devices 112, internal interconnections 114 and a lower interlayer insulating layer 116. The integrated circuit devices 112 may include a memory cell array including switching devices and data storage elements, and logic devices including a MOSFET, a capacitor, and a resistor. The internal interconnections 114 may be disposed on the integrated circuit devices 112 and may be electrically connected to at least one of the integrated circuit devices 112. The integrated circuit devices 112 may be disposed in the device region DR. The internal interconnections 114 may be disposed in the device region DR and the edge region ER, and in some example embodiments, the internal interconnections 114 may also be disposed in the cutting region CR. The lower interlayer insulating layer 116 may cover the semiconductor substrate 102, the integrated circuit devices 112 and the internal interconnections 114. The internal interconnections 114 may include copper (Cu), aluminum (Al), tungsten (W), nickel (Ni), titanium (Ti), titanium nitride (TiN), tantalum (Ta), tantalum nitride (TaN), gold (Au), or a combination thereof. The lower interlayer insulating layer 116 may include silicon oxide, silicon nitride, silicon oxynitride, or a combination thereof. For example, the lower interlayer insulating layer 116 may include silicon oxide.

The interconnection region 120 may be formed on the device region 110. The interconnection region 120 may include a lower insulating layer 122, lower contacts 124 and lower interconnections 126. The lower insulating layers 122 may be deposited sequentially on the lower interlayer insulating layer 116. The lower interconnections 126 may be disposed in the device region DR and may be buried in the lower insulating layers 122. At least one lower interconnection 126 may be electrically connected to the integrated circuit device 112. The lower interconnections 126 may include copper (Cu), aluminum (Al), tungsten (W), nickel (Ni), titanium (Ti), titanium nitride (TiN), tantalum (Ta), tantalum nitride (TaN), gold (Au), or a combination thereof. For example, the lower interconnections 126 may include copper (Cu).

The insulating structure 130 may be formed on the interconnection region 120. The insulating structure 130 may include a first upper insulating layer 132, a second upper insulating layer 134 and a third upper insulating layer 136, and a lower conductive pattern 137 may be formed in the insulating structure 130. In an example embodiment, a portion of the second upper insulating layer 134 overlapping the lower conductive pattern 137 in the vertical direction may protrude upwardly. The second upper insulating layer 134 may include a material having etch selectivity with respect to the first upper insulating layer 132. For example, the first upper insulating layer 132 may include high density plasma (HDP) oxide. The second upper insulating layer 134 may include silicon nitride, silicon oxynitride, silicon carbonitride, or a combination thereof. In an example embodiment, the third upper insulating layer 136 may include silicon oxide. For example, the third upper insulating layer 136 may include tetraethyl orthosilicate (TEOS).

The interlayer insulating layer 128 may be formed between the interconnection region 120 and the insulating structure 130. The first conductive via 129 may penetrate the interlayer insulating layer 128. The first conductive via 129 may connect the lower conductive patterns 137 to the interconnection region 120 in the insulating structure 130. The interlayer insulating layer 128 may include an oxide, a nitride, or a combination thereof.

The lower conductive patterns 137 may include a lower metal layer 137a and a lower anti-reflective layer 137b on the lower metal layer 137a. The lower metal layer 137a may include a conductive material. The lower metal layer 137a may include copper (Cu), aluminum (Al), tungsten (W), nickel (Ni), titanium (Ti), titanium nitride (TiN), tantalum (Ta), tantalum nitride (TaN), gold (Au), or a combination thereof. For example, the lower metal layer 137a may include aluminum (Al). The lower anti-reflective layer 137b may be formed to protect a lower conductive pattern 137 in the process of etching the first upper insulating layer 132, the second upper insulating layer 134, and the third upper insulating layer 136 to form the second conductive via 138. The lower anti-reflective layer 137b may include at least one of titanium (Ti), tantalum (Ta), tantalum nitride (TaN), titanium nitride (TiN), titanium silicon nitride (TiSiN), tungsten (W), tungsten nitride (WN), tungsten carbide (WC), and tungsten carbonitride (WCN). For example, the anti-reflective layer 137b may include titanium nitride (TiN).

The first conductive via 129 may include a first barrier layer 129b and a first metal layer 129a disposed along sidewalls. The first barrier layer 129b may cover a side surface and a lower surface of the first metal layer 129a. The first metal layer 129a may include a conductive material, for example, tungsten (W). The first metal layer 129a and the lower metal layer 137a may include different materials, but an example embodiment thereof is not limited thereto. The first barrier layer 129b may include a metal nitride such as tantalum nitride (TaN), titanium nitride (TiN), or tungsten nitride (WN), for example, titanium nitride (TiN).

Hereinafter, a second metal layer 138a of the second conductive via 138 may include an upper vertical portion 138a1, which is a portion disposed on a level lower than a level of an upper surface of the third upper insulating layer 136 with respect to the upper surface of the third upper insulating layer 136, and an upper horizontal portion 138a2, which is a portion disposed on a level higher than a level of the upper surface of the third upper insulating layer 136. A second barrier layer 138b of the second conductive via 138 may include a first upper portion 138b1, which is a portion disposed on a level lower than a level of the upper surface of the third upper insulating layer 136, and a second upper portion 138b2, which is a portion disposed on a level higher than a level of the upper surface of the third upper insulating layer 136. The terms "higher" and "lower" are used herein relative to a frame of reference, for example, relative to the substrate 102. The second upper portion 138b2 may be referred to as the third barrier layer 138b2, and the upper horizontal portion 138a2 may be referred to as the third metal layer 138a2.

The upper conductive patterns 150 may include the second upper portion 138b2 of the second barrier layer 138b covering a portion of the upper surface of the insulating structure 130, an upper horizontal portion 138a2 of the second metal layer 138a covering the second barrier layer 138b on the insulating structure 130, an upper metal layer 150a on the second metal layer 138a, and an upper anti-reflective layer 150b on the upper metal layer 150a. In an example embodiment, the upper conductive patterns 150 may include an upper horizontal portion 138a2 and a second upper portion 138b2. In an example embodiment, each of the upper conductive patterns 150 may include a third barrier layer 138b2 extending from the second barrier layer 138b and covering a portion of the upper surface of the insulating structure 130, and a third metal layer 138a2 disposed on the third barrier layer 138b2 and the second metal layer 138a1 and extending from the second metal layer 138a1. The upper conductive pattern 150 may include first conductive layers 138a2 and 138b2 extending from the second conductive vias 138, a second conductive layer 150a on the first conductive layers 138a2 and 138b2, and a third conductive layer 150b on the second conductive layer 150a. The first conductive layers 138a2 and 138b2 may include a third metal layer 138a2 (upper horizontal portion 138a2) extending from the second metal layer 138a and a third barrier layer 138b2 (second upper portion 138b2) extending from the second barrier layer 138b. The second conductive layer 150a and the third conductive layer 150b may be referred to as an upper metal layer 150a and an upper anti-reflective layer 150b, respectively.

A thickness Tu of each of the upper conductive patterns 150 may be greater than a thickness Tb of each of the lower conductive patterns 137. A thickness Duu of the upper metal layer 150a may be greater than a thickness Dub of the second metal layer 138a on the upper surface of the insulating structure 130. For example, the thickness Duu of the upper metal layer 150a may be greater than the thickness Dub of the upper horizontal portion 138a2. In an example embodiment, since the upper horizontal portion 138a2 of the second metal layer 138a is present below the upper metal layer 150a, the upper metal layer 150a may be spaced apart from the upper surface of the insulating structure 130. For example, the upper metal layer 150a may be spaced apart from the upper surface of the third upper insulating layer 136. The second metal layer 138a in the upper conductive patterns 150, that is, the upper horizontal portion 138a2, may extend to the second metal layer 138a in the insulating structure 130, that is, the upper vertical portion 138a1. In other words, the upper conductive patterns 150 may include portions of a second metal layer 138a that continuously extends into the via openings, such that the upper vertical portions 138a1 in the via openings and the upper horizontal portions 138a2 outside the via openings form an integral or unitary structure. The semiconductor device 100 as described above may reduce contact resistance by increasing a contact area between the upper metal layer 150a and the first metal layer 129a (in particular, by increasing contact area between the upper metal layer 150a and the upper horizontal portion 138a2 of the second metal layer 138a), and electro-migration properties of the upper conductive patterns 150 may be improved due to the second metal layer 138a in the upper conductive patterns 150. For example, the upper metal layer 150a may include aluminum (Al) and the first metal layer 129a or the second metal layer 138a may include tungsten (W), such that electro-migration properties of the upper conductive patterns 150 may be improved. Accordingly, the semiconductor device 100 having improved electrical properties and reliability may be provided.

The upper anti-reflective layer 150b may be formed to protect the upper conductive pattern 150 in the process of etching the passivation structure P to form the opening OP. The upper metal layer 150a may include a conductive material, for example, aluminum (Al). The upper anti-reflective layer 150b may include at least one of titanium (Ti), tantalum (Ta), tantalum nitride (TaN), titanium nitride (TiN), titanium silicon nitride (TiSiN), tungsten (W), tungsten nitride (WN), and tungsten carbide (WC), and tungsten carbonitride (WCN). For example, the upper anti-reflective layer 150b may include titanium nitride (TiN).

The second conductive via 138 may include a second barrier layer 138b and a second metal layer 138a disposed along sidewalls. The second barrier layer 138b, that is, the first upper portion 138b1, may cover a side surface and a lower surface of the second metal layer 138a. The second metal layer 138a may include a conductive material, for example, tungsten (W). The second metal layer 138a and the upper metal layer 150a may include different materials, but an example embodiment thereof is not limited thereto. The second barrier layer 138b may include a metal nitride, such as tantalum nitride (TaN), titanium nitride (TiN), or tungsten nitride (WN), for example, titanium nitride (TiN). The first conductive via 129 and the second conductive via 138 may have similar structures. In an example embodiment, the second barrier layer 138b may be disposed between the insulating structure 130 and the second metal layer 138a. For example, the second barrier layer 138b may cover a portion of an upper surface of the third upper insulating layer 136. That is, the second upper portion 138b2 may cover a portion of the upper surface of the third upper insulating layer 136.

The passivation structure P may include a protective layer 160, a first passivation layer 164, and a second passivation layer 168. The passivation structure P may cover an internal wall of the trench T formed along the cutting region CR.

The protective layer 160 may be formed conformally along at least a portion of the second barrier layer 138b and the upper conductive pattern 150. The protective layer 160 may include the same material as that of the third upper insulating layer 136 and may include, for example, TEOS. In an example embodiment (not shown), the second barrier layer 138b, that is, the second upper portion 138b2, may be present between the protective layer 160 and the third upper insulating layer 136 such that the protective layer 160 and the third upper insulating layer 136 may be distinct from each other, but an example embodiment thereof is not limited thereto.

The first passivation layer 164 may cover the protective layer 160. The first passivation layer 164 may include silicon oxide, for example, TEOS. The second passivation layer 168 may be formed conformally along the first passivation layer 164 and a trench T. The second passivation layer 168 may include silicon nitride, silicon oxynitride, silicon carbonitride, or a combination thereof. For example, the second passivation layer 168 may include silicon nitride.

A guard ring 140 is disposed in the edge region ER and may extend in the horizontal direction to surround the device region DR. As in FIG. 3C, the guard ring 140 may have a quadrangular shape, but an example embodiment thereof is not limited thereto. According to another example embodiment, the guard ring 140 may have a circular shape or an oval shape. The cutting region CR may be disposed on an external side of (i.e., outside a perimeter of) the guard ring 140 and may surround the guard ring 140. The trench T may extend in one or more horizontal directions along the cutting region CR.

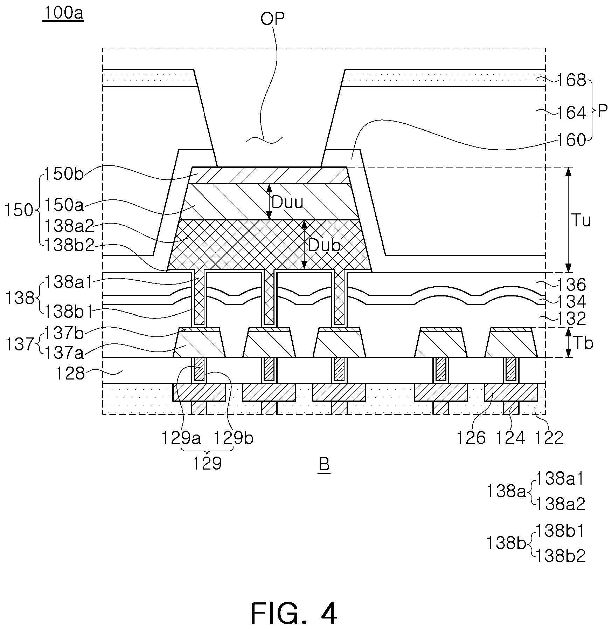

FIGS. 4 to 9 are enlarged cross-sectional diagrams illustrating a portion of a semiconductor device according to example embodiments.

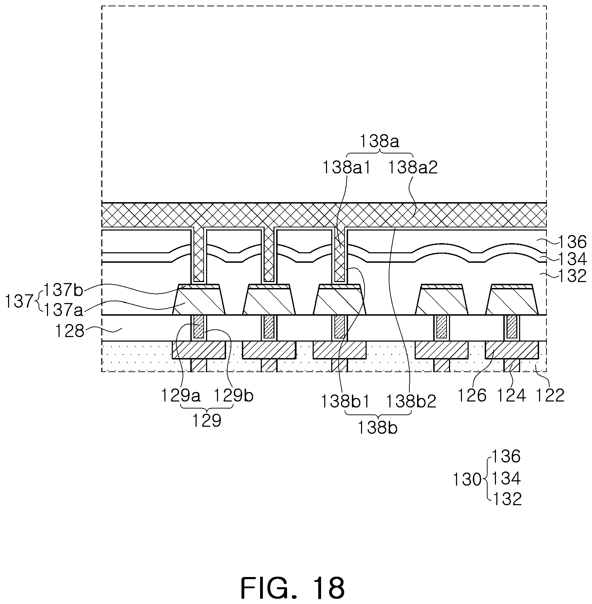

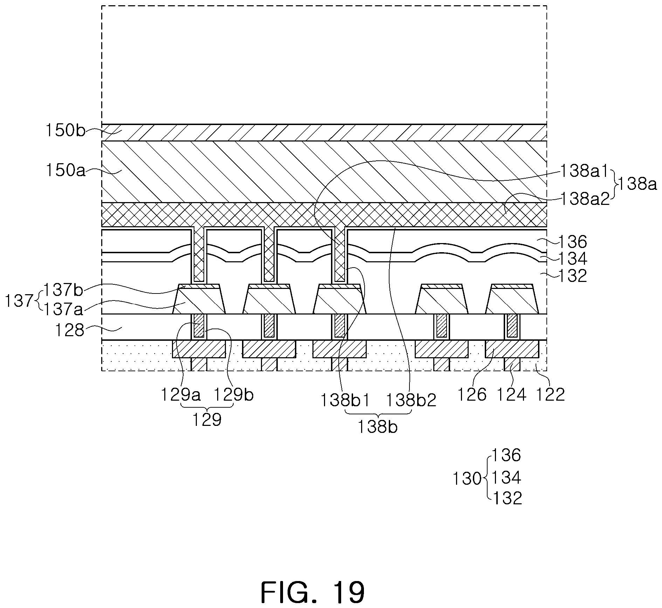

Referring to FIG. 4, in a semiconductor device 100a, a thickness Duu of the upper metal layer 150a may be substantially equal to or smaller than a thickness Dub of the second metal layer 138a on an upper surface of the insulating structure 130. For example, the thickness Duu of the upper metal layer 150a may be substantially equal to or smaller than the thickness Dub of the upper horizontal portion 138a2 on the upper surface of the insulating structure 130. In an example embodiment, in the process in FIGS. 18 and 19 described later, the upper horizontal portion 138a2 of the second metal layer 138a may be configured to have a greater thickness, and the upper metal layer 150a may be configured to have a thickness smaller than that of the first metal layer 129a.

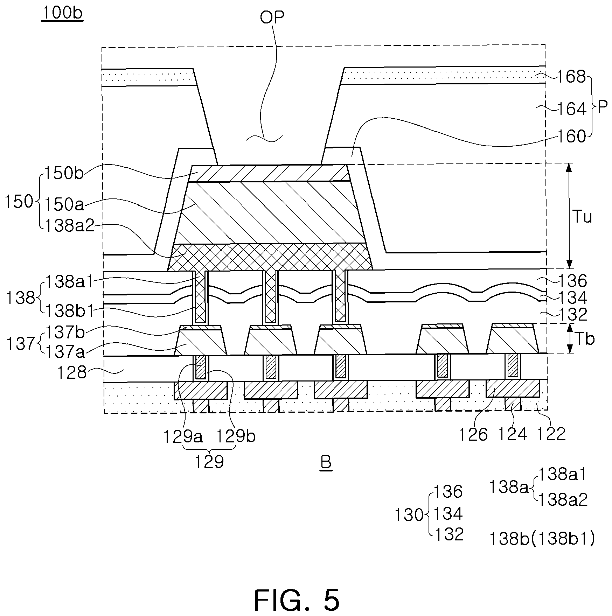

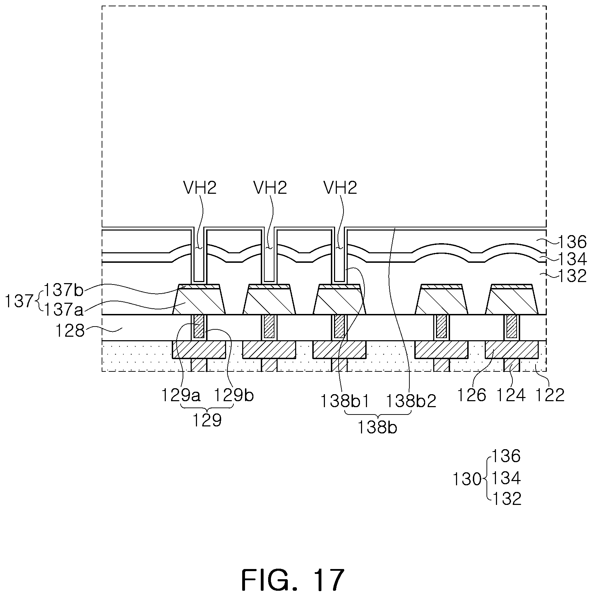

Referring to FIG. 5, in a semiconductor device 100b, the second metal layer 138a may be in direct contact with the upper surface of the insulating structure 130. This is because, in the process in FIG. 17 described later, the second barrier layer 138b may be formed in the second via hole VH2 and may not be formed on the upper surface of the third upper insulating layer 136, or in the process in FIG. 18, the process may be performed after the second upper portion 138b2 of the second barrier layer 138b on the third upper insulating layer 136 is removed by a planarization process before the second metal layer 138a is formed.

The protective layer 160 may be conformally formed along the insulating structure 130 and upper conductive pattern 150. In an example embodiment, the boundary between the protective layer 160 and the third upper insulating layer 136 may not be identified, and since the second upper portion 138b2 of the second barrier layer 138b is not present on the upper surface of the third upper insulating layer 136, the protective layer 160 may be integrally connected to the third upper insulating layer 136, that is, as a unitary layer free of a boundary therebetween.

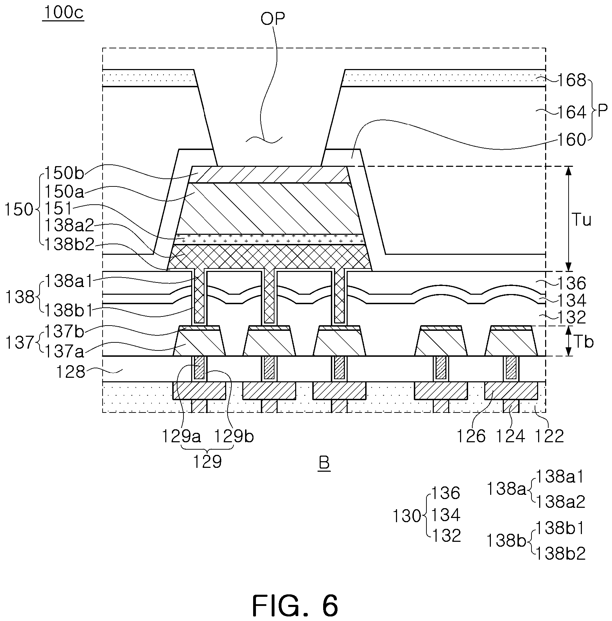

Referring to FIG. 6, in a semiconductor device 100c, the upper conductive patterns 150 may further include an upper barrier layer 151 between the upper metal layer 150a and the upper horizontal portion 138a2 of the second metal layer 138a. The upper barrier layer 151 may be formed to cover the upper surface of the upper horizontal portion 138a2 of the second metal layer 138a. The upper barrier layer 151 may include Ti, TiN, Ta, TaN, WN, or a combination thereof.

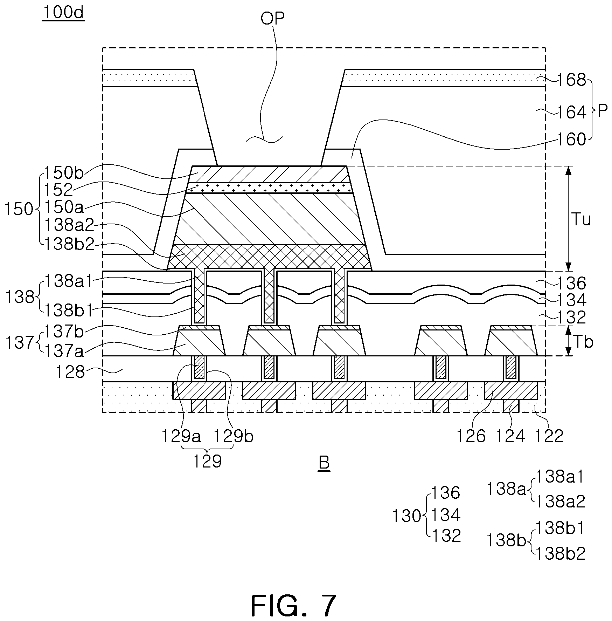

Referring to FIG. 7, in a semiconductor device 100d, each of the upper conductive patterns 150 may further include an oxide layer 152 between the upper metal layer 150a and the upper anti-reflective layer 150b. In the process of forming the upper anti-reflective layer 150b on the upper metal layer 150a, the oxide layer 152 may be formed by a heat treatment process. The oxide layer 152 may include a conductive metal oxide.

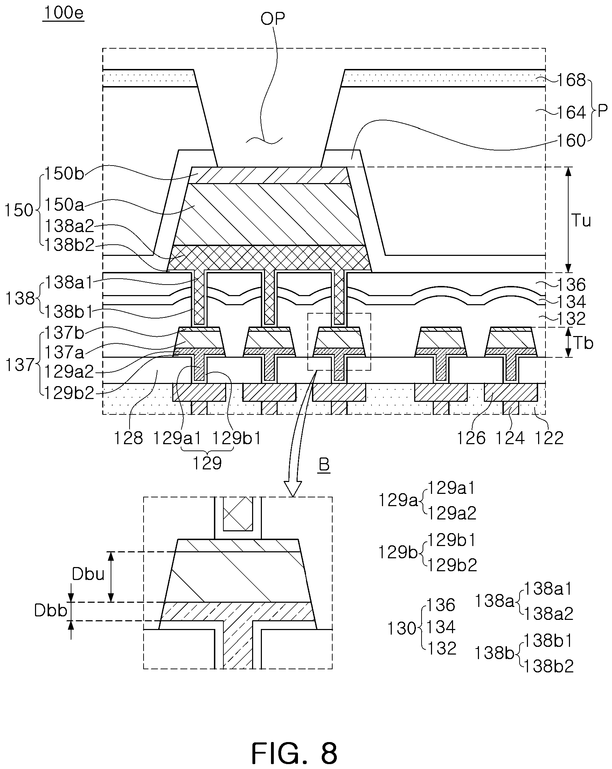

Referring to FIG. 8, in a semiconductor device 100e, each of lower conductive patterns 137 may include a first barrier layer 129b covering a portion of the upper surface of the interlayer insulating layer 128, and a first metal layer 129a covering the first barrier layer 129b on the interlayer insulating layer 128. For example, the lower conductive patterns 137 may include a second lower portion 129b2 of the first barrier layer 129b, a lower horizontal portion 129a2 of the first metal layer 129a, a lower metal layer 137a, and a lower anti-reflective layer 137b.

The first metal layer 129a may include a lower vertical portion 129a1, which is a portion disposed on a level lower than a level of an upper surface of the interlayer insulating layer 128 with respect to an upper surface of the interlayer insulating layer 128, and a lower horizontal portion 129a2, which is a portion disposed on a level higher than a level of an upper surface of interlayer insulating layer 128 relative to the semiconductor substrate 102. The first barrier layer 129b may include a first lower portion 129b1, which is a portion disposed on a level lower than a level of the upper surface of the interlayer insulating layer 128, and a second lower portion 129b2, which is a portion disposed on a level higher than a level of the upper surface of the interlayer insulating layer 128, relative to the semiconductor substrate 102.

In an example embodiment, the lower conductive patterns 137 and the upper conductive patterns 150 may have similar structures. The first metal layer 129a in the lower conductive patterns 137, that is, the lower horizontal portion 129a2, may extend to the first metal layer 129a in the first conductive via 129, that is, the first lower portion 129a1. A thickness Dbu of the lower metal layer 137a may be greater than a thickness Dbb of the first metal layer 129a on the upper surface of the interlayer insulating layer 128. For example, the thickness Dbu of the lower metal layer 137a may be greater than the thickness Dbb of the lower horizontal portion 129a2 on the upper surface of the interlayer insulating layer 128. The semiconductor device 100e may reduce contact resistance by increasing a contact area between the lower metal layer 137a and the lower horizontal portion 129a2 of the first metal layer 129a. Accordingly, the semiconductor device 100e having improved electrical properties and reliability may be provided.

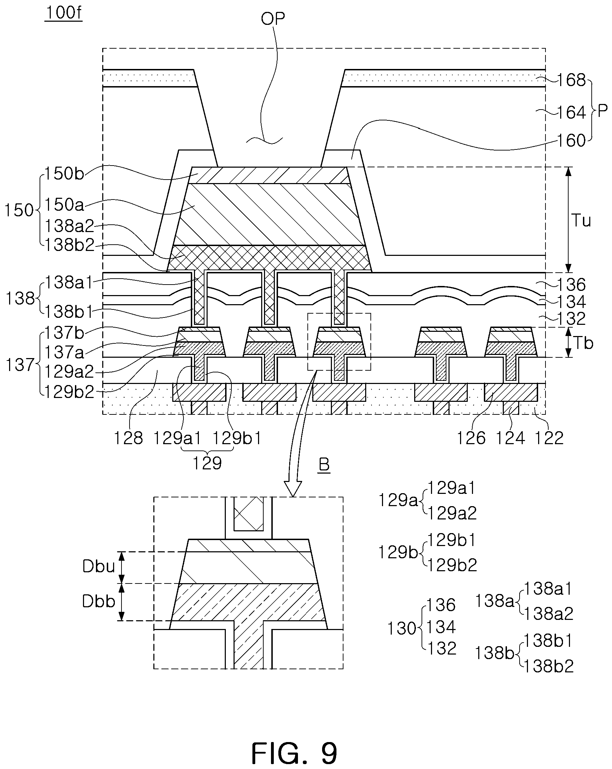

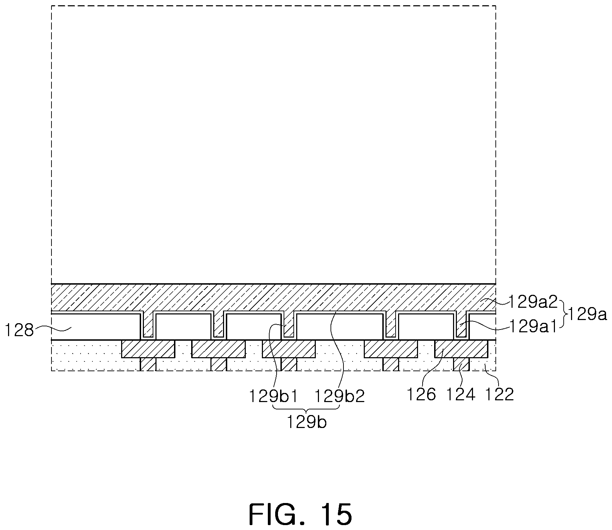

Referring to FIG. 9, in a semiconductor device 100f, a thickness Dbu of the lower metal layer 137a may be substantially equal to or smaller than a thickness Dbb of the first metal layer 129a on the upper surface of the interlayer insulating layer 128. In an example embodiment, in the process in FIGS. 15 to 16B described later, the first metal layer 129a (and in particular, the lower horizontal portion 129a2) may be configured to have a greater thickness, and the lower metal layer 137a may be configured to have a thickness smaller than the lower horizontal portion 129a2 of the first metal layer 129a.

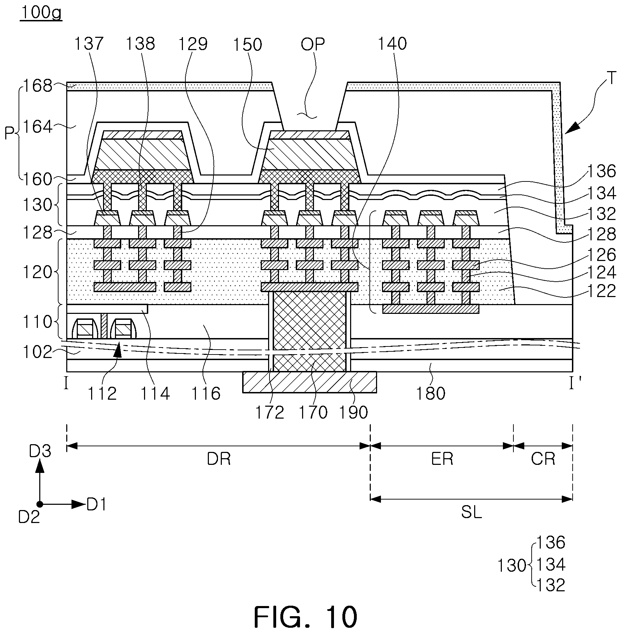

FIG. 10 is a cross-sectional diagram illustrating a semiconductor device according to an example embodiment.

Referring to FIG. 10, the semiconductor device 100g may further include a through-electrode 170, a via insulating layer 172, a lower passivation layer 180 and a via pad 190. The through-electrode 170 may vertically penetrate the semiconductor substrate 102 and the device region 110 and may be connected to the interconnection region 120. The via insulating layer 172 may cover a side surface of the through-electrode 170. The through-electrode 170 may include copper (Cu), aluminum (Al), tungsten (W), nickel (Ni), titanium (Ti), titanium nitride (TiN), tantalum (Ta), tantalum nitride (TaN), and gold (Au), or a combination thereof. The via insulating layer 172 may include an insulating material such as silicon oxide.

The lower passivation layer 180 may cover a lower surface of the semiconductor substrate 102, and the through-electrode 170 may penetrate the lower passivation layer 180. The via pad 190 may be disposed on a lower surface of the lower passivation layer 180 and may be connected to the through-electrode 170. The via pad 190 may be electrically connected to the interconnection region 120 through the through-electrode 170. According to another example embodiment, the via pad 190 may overlap the lower passivation layer 180 in the horizontal direction, and the side surface of the via pad 190 may be in contact with the lower passivation layer 180.

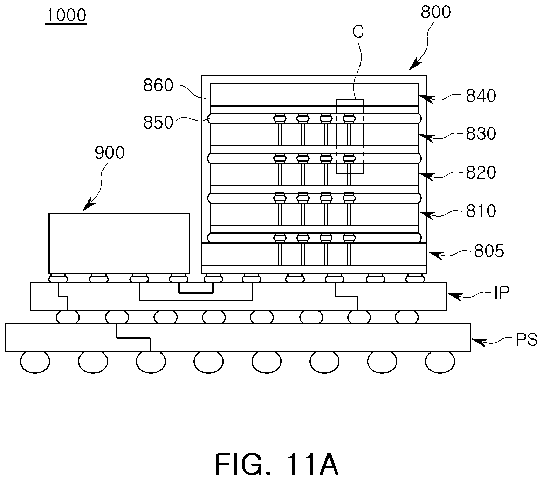

FIG. 11A is a cross-sectional diagram illustrating a semiconductor package including a semiconductor device according to an example embodiment.

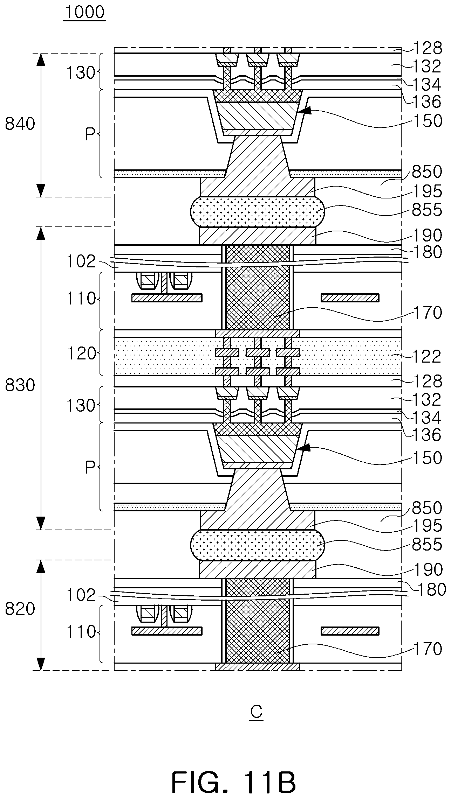

FIGS. 11B is an enlarged cross-sectional diagram illustrating a portion of the semiconductor package illustrated in FIG. 11A according to example embodiments corresponding to region "C" in FIG. 11A.

Referring to FIGS. 11A and 11B, a semiconductor package 1000 of the present disclosure may be configured as a high bandwidth memory (HBM) package. The semiconductor package 1000 may include a package substrate PS, an interposer IP mounted on the package substrate PS, a memory package 800 mounted on the interposer IP, and a processor chip 900. The interposer IP may electrically connect the memory package 800 to the processor chip 900.

The memory package 800 may include a buffer chip 805, a first semiconductor device 810, a second semiconductor device 820, a third semiconductor device 830 and a fourth semiconductor device 840, which may be stacked sequentially. The buffer chip 805 and the first to fourth semiconductor devices 810, 820, 830, and 840 may have a structure the same as or similar to that of the semiconductor device 100 described with reference to FIGS. 3A and 3B, and may include components corresponding to the upper conductive pattern 150 and the lower conductive pattern 137, for example. Also, the second to fourth semiconductor devices 820, 830, and 840 may include components corresponding to the through-electrode 170, the via insulating layer 172, the lower passivation layer 180, and the via pad 190.

In an example embodiment, the buffer chip 805 may be configured as a different type of semiconductor chip from the first to fourth semiconductor devices 810, 820, 830, and 840. For example, the buffer chip 805 may be configured as a logic chip, and the first to fourth semiconductor devices 810, 820, 830, and 840 may be configured as memory chips. The logic chip may include a microprocessor, an analog device, or a digital signal processor. The memory chip may include a volatile memory chip such as dynamic random access memory (DRAM) or static random access memory (SRAM), or a non-volatile memory chip such as phase-change random access memory (PRAM), magnetoresistive random access memory (MRAM), ferroelectric random access memory (FeRAM), or resistive random access memory (RRAM).

The memory package 800 may further include an adhesive layer 850 and an encapsulant 860. The adhesive layer 850 may be disposed between the buffer chip 805 and the first semiconductor device 810 and between the first to fourth semiconductor devices 810, 820, 830, and 840. The adhesive layer 850 may be a non-conductive film (NCF) or a non-conductive paste (NCP). An encapsulant 860 may be a resin containing epoxy or polyimide. For example, the resin may include bisphenol-group epoxy resin, polycyclic aromatic epoxy resin, o-cresol novolac epoxy resin, biphenyl-based epoxy resin, or naphthalene-group epoxy resin.

The processor chip 900 may be implemented as a central processing unit (CPU), a graphics processing unit (GPU), a mobile application, or a digital signal processor (DSP) chip.

As illustrated in FIG. 11B, the memory package 800 may further include conductive bumps 855 between the second semiconductor device 820 and the third semiconductor device 830 and between the third semiconductor device 830 and the fourth semiconductor device 840. The first to fourth semiconductor devices 810, 820, 830, and 840 may further include a connection pad 195 connected to the upper conductive pattern 150. The upper conductive pattern 150 and the lower conductive pattern 137 may be configured to be the same as or similar to the components of the semiconductor device 100 illustrated in FIGS. 3A and 3B. The upper conductive pattern 150 and the lower conductive pattern 137 may be configured to be the same as or similar to the components of the semiconductor device 100e illustrated in FIG. 8 or the semiconductor device 100f illustrated in FIG. 9. The connection pad 195 may fill the opening OP illustrated in FIG. 10 and may be in contact with the upper conductive pattern 150. The connection pad 195 may penetrate the passivation structure P and may be in contact with side surfaces of the structure. The bump 855 may connect the via pad 190 to the connection pad 195 between adjacent semiconductor devices 820, 830, and 840. The adhesive layer 850 may cover the side surfaces of the via pad 190, the connection pad 195 and the bump 855. According to another example embodiment, the bump 855 may not be provided, and the via pad 190 and the connection pad 195 may be in direct contact with each other.

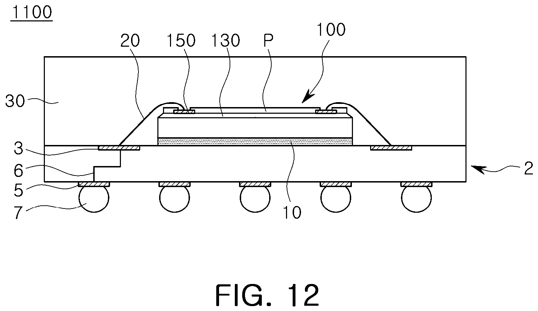

FIG. 12 is a cross-sectional diagram illustrating a semiconductor package including a semiconductor device according to an example embodiment.

Referring to FIG. 12, a semiconductor package 1100 may include a substrate 2, an adhesive member 10, a bonding wire 20, and an encapsulant 30. The semiconductor package 1000 may also include a semiconductor device 100 on the substrate 2.

The substrate 2 may include upper pads 3, lower pads 5, an internal interconnection 6 and an external connection terminal 7. In an example embodiment, substrate 2 may be implemented as a printed circuit board and may include an insulating material such as phenolic resin, epoxy resin, or prepreg. In another example embodiment, the substrate 2 may be configured as a redistribution layer in which an insulating material and a conductive material are stacked. The upper pads 3 and the lower pads 5 may be formed by forming a metal layer on a base of the substrate 2 and patterning the metal layer.

The upper pads 3 may be disposed on an upper surface of the substrate 2 and may be electrically connected to the semiconductor device 100. The lower pads 5 may be disposed on a lower surface of substrate 2, and the upper pads 3 may be electrically connected to the corresponding lower pad 5 by an internal interconnection 6. The external connection terminals 7 may be disposed below the lower pads 5. The lower pad 5, the upper pad 3 and the interconnection may include metal such as copper (Cu). The external connection terminal 7 may be configured as a conductive bump 855 (e.g., a solder bump).

The semiconductor device 100 may include an insulating structure 130, an upper conductive pattern 150 and a passivation structure P, which may be the same as or similar to the components of the semiconductor device 100 illustrated in FIGS. 3A and 3B. The insulating structure 130 may be disposed on the semiconductor device 100. The passivation structure P may be disposed on the upper insulating structure 130 and may protect the upper insulating structure 130 from external physical impacts. The upper conductive pattern 150 may be buried in the passivation structure P. The upper conductive pattern 150 may be connected to the upper pad 3 by a bonding wire 20.

The adhesive member 10 may be disposed between the substrate 2 and the semiconductor device 100. The adhesive member 10 may fix or attach the semiconductor device 100 to the substrate 2. The adhesive member 10 may be configured as a die attach film (DAF), but an example embodiment thereof is not limited thereto. The encapsulant 30 may cover the substrate 2, the semiconductor device 100 and the bonding wire 20.

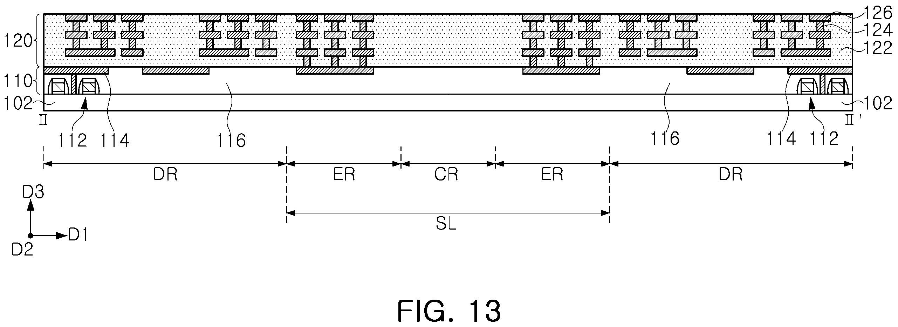

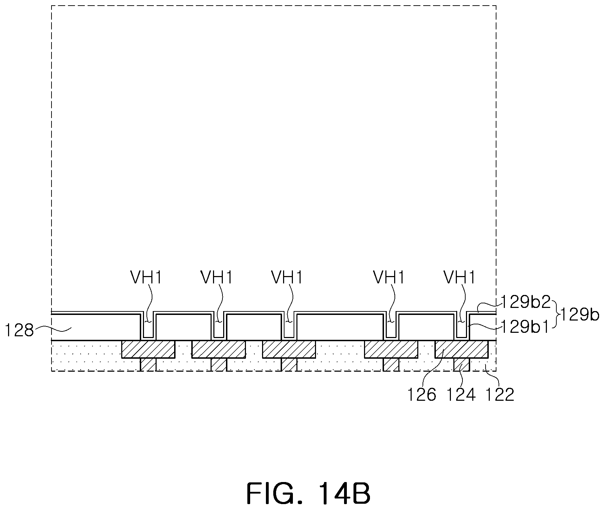

FIGS. 13 to 26 are cross-sectional diagrams and enlarged cross-sectional diagrams illustrating processes of a method of manufacturing a semiconductor device sequentially on a semiconductor substrate, according to an example embodiment. FIGS. 13, 14A, 16A, and 22 to 26 are cross-sectional diagrams taken along line II-II' in FIG. 2. FIGS. 14B, 15, 16B, and 17 to 21 illustrate regions corresponding to FIG. 3B.

Referring to FIG. 13, a device region 110 and an interconnection region 120 may be formed on the semiconductor substrate 102. The semiconductor substrate 102 may correspond to the semiconductor substrate or wafer W illustrated in FIG. 1.

The semiconductor substrate 102 may include device regions DR and a scribe line region SL between the device regions DR. The scribe line region SL may include edge regions ER and a cutting region CR between the edge regions ER. The edge region ER may surround the device region DR. The cutting region CR may refer to a portion isolated during the dicing process described later. The semiconductor substrate 102 may include a semiconductor material.

The device region 110 may include integrated circuit devices 112, internal interconnections 114 and a lower interlayer insulating layer 116. The integrated circuit devices 112 may be disposed in the device region DR. The internal interconnection 114 may be disposed in the device region DR and the edge region ER, and in some example embodiments, the internal interconnection 114 may also be disposed in the cutting region CR. The lower interlayer insulating layer 116 may cover the semiconductor substrate 102, the integrated circuit devices 112 and the internal interconnections 114.

The interconnection region 120 may be formed on the device region 110. The interconnection region 120 may include lower insulating layers 122, lower contacts 124 and lower interconnections 126.

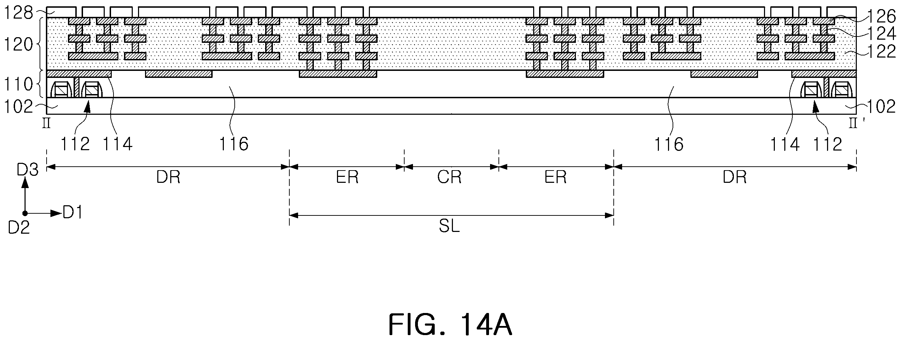

Referring to FIGS. 14A and 14B, an interlayer insulating layer 128 and a first via hole VH1 vertically penetrating the interlayer insulating layer 128 may be formed on the interconnection region 120, and a first barrier layer 129b may be formed in the first via hole VH1.

The first via hole VH1 may be formed using dry etching, wet etching, laser drilling, or mechanical drilling methods. The first lower portion 129b1 of the first barrier layer 129b may be formed to have a uniform thickness on a lower surface and a side surface of the first via hole VH1. In an example embodiment, the second lower portion 129b2 of the first barrier layer 129b may cover the interlayer insulating layer 128. For example, the second lower portion 129b2 of the first barrier layer 129b may be formed on an upper surface of the interlayer insulating layer 128. However, an example embodiment thereof is not limited thereto, and the first barrier layer 129b may not cover or may be removed from the upper surface of the interlayer insulating layer 128 and may be formed in the first via hole VH1. The first barrier layer 129b may be formed by a physical vapor deposition (PVD) process, a chemical vapor deposition (CVD) process, or an atomic layer deposition (ALD) process.

Referring to FIG. 15, the first metal layer 129a may be formed to fill the first via hole VH1.

The first metal layer 129a may be configured to fill the first via hole VH1 entirely. For example, the lower vertical portion 129a1 of the first metal layer 129a may fill the first via hole VH1. In an example embodiment, the lower horizontal portion 129a2 of the first metal layer 129a may be formed to cover the first barrier layer 129b on the upper surface of the interlayer insulating layer 128. In this case, the semiconductor device 100e in FIG. 8 may be manufactured, and when the first metal layer 129a is formed to a greater thickness, the semiconductor device 100f in FIG. 9 may be manufactured. However, an example embodiment thereof is not limited thereto, and the lower horizontal portion 129a2 of the first metal layer 129a may be formed to cover the upper surface of the interlayer insulating layer 128 after the first barrier layer 129b on the upper surface of the interlayer insulating layer 128 is removed through a planarization process, and the lower horizontal portion 129a2 may fill the first via hole VH1 entirely. The first metal layer 129a may be formed by a PVD process, a CVD process, or an ALD process.

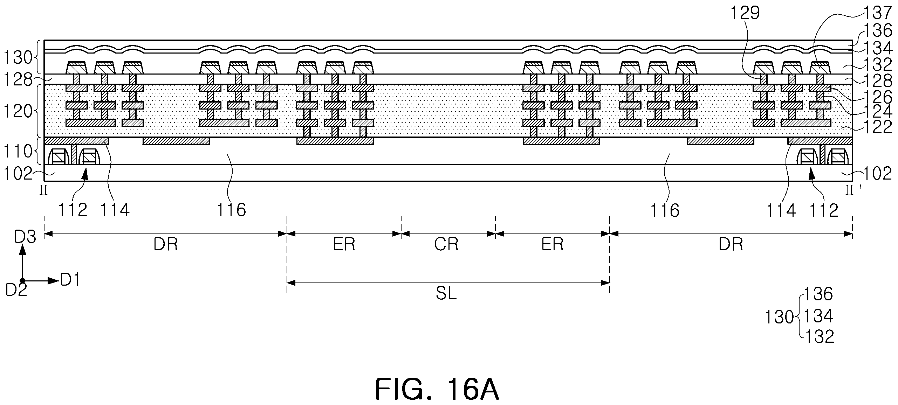

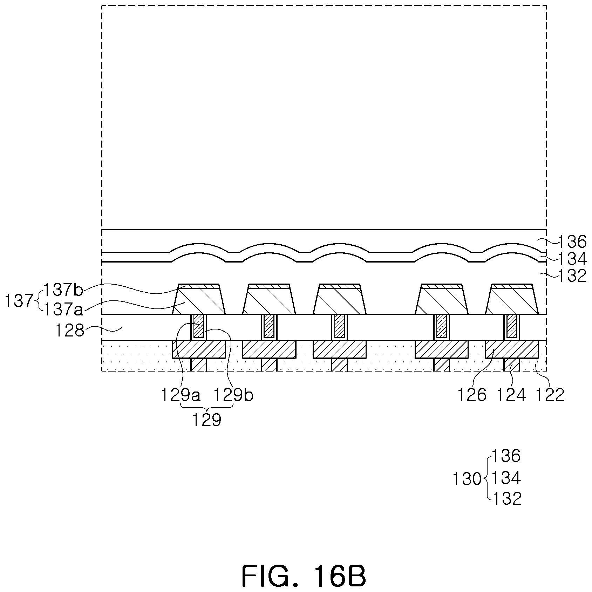

Referring to FIGS. 16A and 16B, a first conductive via 129 may be formed, and a lower conductive pattern 137 may be formed on the first conductive via 129. Thereafter, the insulating structure 130 may be formed on the interconnection region 120.

The first conductive via 129 may be formed by removing the first metal layer 129a and the first barrier layer 129b from the upper surface of the interlayer insulating layer 128 by a planarization process, but an example embodiment thereof is not limited thereto. To manufacture the semiconductor device 100e in FIG. 8 or the semiconductor device 100f in FIG. 9, the planarization process may not be performed.

The lower conductive pattern 137 may be formed by forming a lower metal layer 137a on the interlayer insulating layer 128, forming a lower anti-reflective layer 137b on the lower metal layer 137a, and performing a photo process and an etching process. Since the lower conductive pattern 137 may be formed by the same or similar process as the process of forming the upper conductive pattern 150, which will be described later, the process of forming the upper conductive pattern 150, which will be described later, may be applied in the same or similar manner. The lower conductive pattern 137 may be disposed in the device region DR and the edge region ER, and at least one of the lower conductive patterns 137 may be electrically connected to a respective lower interconnection 126.

The insulating structure 130 may be formed on the interconnection region 120. The insulating structure 130 may include a first upper insulating layer 132, a second upper insulating layer 134 and a third upper insulating layer 136, and a lower conductive pattern 137 may be disposed in the insulating structure 130. The lower conductive pattern 137 may be covered by the first upper insulating layer 132. In an example embodiment, a portion of the second upper insulating layer 134 overlapping the lower conductive pattern 137 in the vertical direction may protrude upwardly. The second upper insulating layer 134 may include a material having etch selectivity with respect to the first upper insulating layer 132. For example, the first upper insulating layer 132 may include high density plasma (HDP) oxide. The second upper insulating layer 134 may include silicon nitride, silicon oxynitride, silicon carbonitride, or a combination thereof. In an example embodiment, the third upper insulating layer 136 may include silicon oxide. For example, the third upper insulating layer 136 may include tetraethyl orthosilicate (TEOS). The lower conductive pattern 137 may be included in an interconnection extending in the horizontal direction and a pad connected to the interconnection.

Referring to FIG. 17, a second via hole VH2 vertically penetrating the insulating structure 130 may be formed, and a second barrier layer 138b may be formed in the second via hole VH2.

The second via hole VH2 may be formed using dry etching, wet etching, laser drilling, or mechanical drilling methods. The second barrier layer 138b may be formed to have a uniform thickness on a lower surface and a side surface of the second via hole VH2. In an example embodiment, the second upper portion 138b2 of the second barrier layer 138b may be formed to cover the third upper insulating layer 136. For example, the second upper portion 138b2 of the second barrier layer 138b may be formed on an upper surface of the third upper insulating layer 136. However, an example embodiment thereof is not limited thereto, and the second barrier layer 138b may not cover or may be removed from the upper surface of the third upper insulating layer 136 and may be formed in the second via hole VH2. The first upper portion 138b1 of the second barrier layer 138b may be formed to surround the lower surface and the side surface of the second via hole VH2. In this case, semiconductor device 100b in FIG. 5 may be manufactured. The second barrier layer 138b may be formed by a PVD process, a CVD process, or an ALD process.

Referring to FIG. 18, a second metal layer 138a may be formed to fill the second via hole VH2.

The second metal layer 138a may be formed to fill the second via hole VH2 entirely. For example, the upper vertical portion 138a1 of the second metal layer 138a may fill the second via hole VH2. In an example embodiment, the upper horizontal portion 138a2 of the second metal layer 138a may be formed to cover the second barrier layer 138b on the third upper insulating layer 136. However, an example embodiment thereof is not limited thereto, and the second metal layer 138a may be formed to cover the upper surface of the third upper insulating layer 136 after the second barrier layer 138b on the upper surface of the third upper insulating layer 136 is removed by a planarization process, and the second metal layer 138a may fill the second via hole VH2. In this case, the second metal layer 138a may be in contact with the upper surface of the third upper insulating layer 136, and the semiconductor device 100b in FIG. 5 may be manufactured. The second metal layer 138a may be formed by a PVD process, a CVD process, or an ALD process. When the second metal layer 138a is formed to have a greater thickness, the semiconductor device 100a in FIG. 4 may be manufactured.

Thereafter, when the upper surface of the second metal layer 138a has a step difference, that is, when the upper surface of the upper horizontal portion 138a2 of the second metal layer 138a has a step difference, a planarization process may optionally be performed to remove the step difference from the upper surface of the second metal layer 138a. In an example embodiment, a buffing CMP process may be performed.

Referring to FIG. 19, the upper metal layer 150a on the second metal layer 138a and the upper anti-reflective layer 150b on the upper metal layer 150a may be formed.

The upper metal layer 150a and the upper anti-reflective layer 150b may be formed by a PVD process, a CVD process, or an ALD process. The thickness of the upper metal layer 150a may be greater than the thickness of the second metal layer 138a (and in particular, greater than the thickness of the upper horizontal portion 138a2) on the insulating structure 130, but an example embodiment thereof is not limited thereto.

To manufacture the semiconductor device 100c in FIG. 6, an upper barrier layer 151 may be formed on the second metal layer 138a before the upper metal layer 150a is formed on the second metal layer 138a. The upper barrier layer 151 may be disposed between the upper surface of the second metal layer 138a and the lower surface of the upper metal layer 150a. The upper barrier layer 151 may include Ti, TiN, Ta, TaN, WN, or a combination thereof.

To manufacture the semiconductor device 100d in FIG. 7, an oxide layer 152 may be formed before the upper anti-reflective layer 150b is formed on the upper metal layer 150a. The oxide layer 152 may be formed to have a uniform thickness. The oxide layer 152 may include a conductive metal oxide, for example, aluminum (Al) oxide. The oxide layer 152 may be formed by a PVD process, a CVD process, or an ALD process, but an example embodiment thereof is not limited thereto.

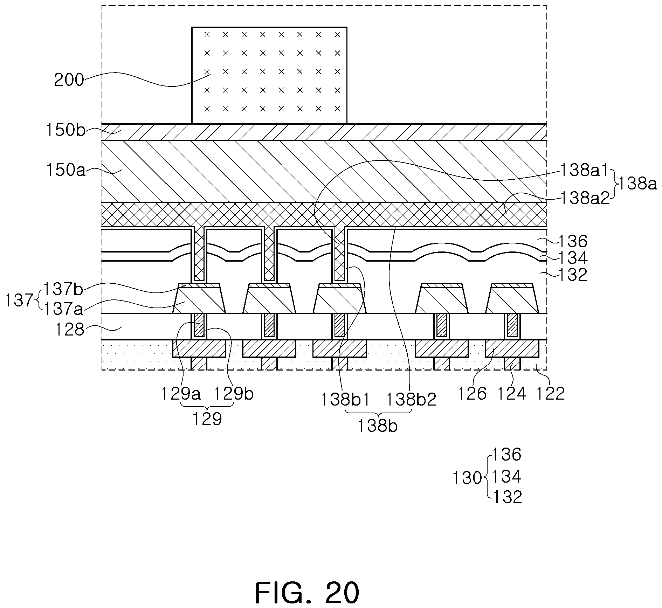

Referring to FIG. 20, a photoresist pattern 200 may be formed on the upper anti-reflective layer 150b.

In some embodiments, to form the photoresist pattern 200, a photoresist layer may be formed on the upper anti-reflective layer 150b. Thereafter, an exposure and development process may be performed on the photoresist layer by irradiating light, and a photoresist pattern 200 may be formed using a photomask to define the region in which the pattern may be formed. When light is irradiated, the upper metal layer 150a may be protected by the upper anti-reflective layer 150b.

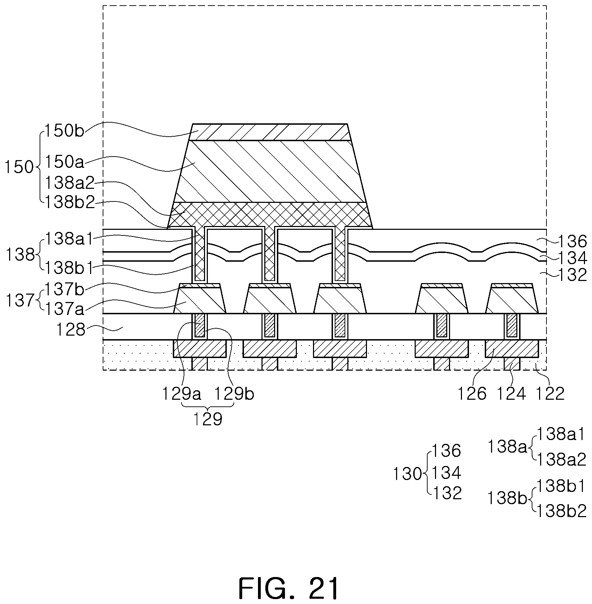

Referring to FIG. 21, the upper metal layer 150a, the upper anti-reflective layer 150b, the second metal layer 138a, and the second barrier layer 138b may be patterned using the photoresist pattern 200 as an etch mask. Accordingly, an upper conductive pattern 150 may be formed.

After the etching process, the photoresist pattern 200 may be removed by an ashing and stripping process. The upper anti-reflective layer 150b may include the same metal element as that of the upper metal layer 150a, but an example embodiment thereof is not limited thereto.

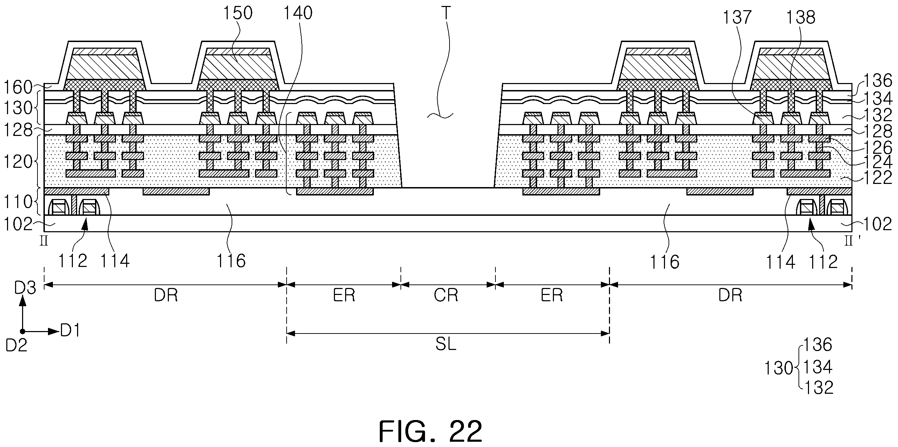

Referring to FIG. 22, a protective layer 160 covering the second barrier layer 138b, the insulating structure 130, and the upper conductive pattern 150 may be formed. The protective layer 160 may be conformally formed along the second barrier layer 138b the insulating structure 130 and the upper conductive pattern 150. The protective layer 160 may include the same material as that of the third upper insulating layer 136 and may include, for example, TEOS. In an example embodiment, a boundary between the protective layer 160 and the third upper insulating layer 136 may not be distinct, and the protective layer 160 may be integrally connected to the third upper insulating layer 136.

After the protective layer 160 is formed, the interconnection region 120, the insulating structure 130, the second barrier layer 138b, and the protective layer 160 may be isolated from each other with an upper surface of the device region 110 exposed therebetween. Side surfaces of the interconnection region 120, the insulating structure 130, the second barrier layer 138b, and the protective layer 160 and the upper surface of device region 110 may define a trench T. The trench T may extend in the horizontal direction to surround the device region DR and the edge region ER. According to another example embodiment, the trench T may not completely cut the interconnection region 120.

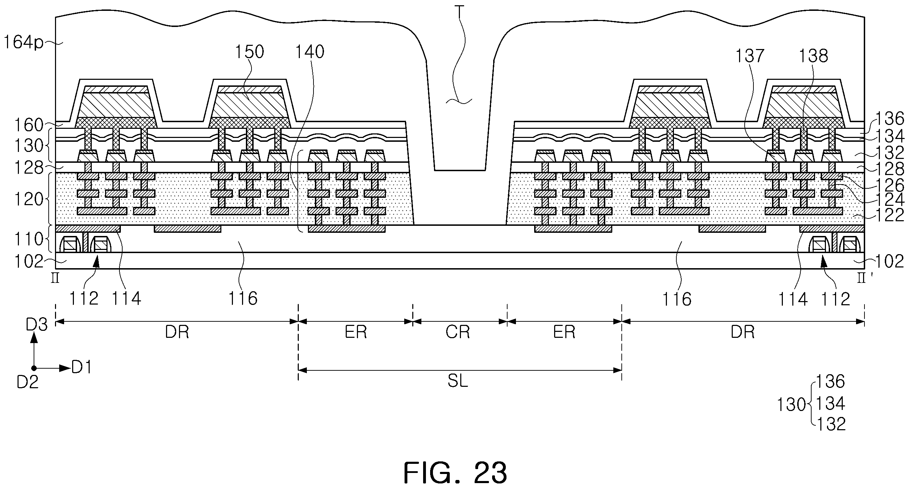

Referring to FIG. 23, an insulating material layer 164p covering the protective layer 160 may be formed. The insulating material layer 164p may fill a space between the upper conductive patterns 150 and may completely cover the upper conductive pattern 150. The insulating material layer 164p may include silicon oxide and, in an example embodiment, the insulating material layer 164p may include TEOS. In an example embodiment, the upper surface of the insulating material layer 164p may not be flat, and for example, a portion corresponding to the upper conductive pattern 150 may protrude.

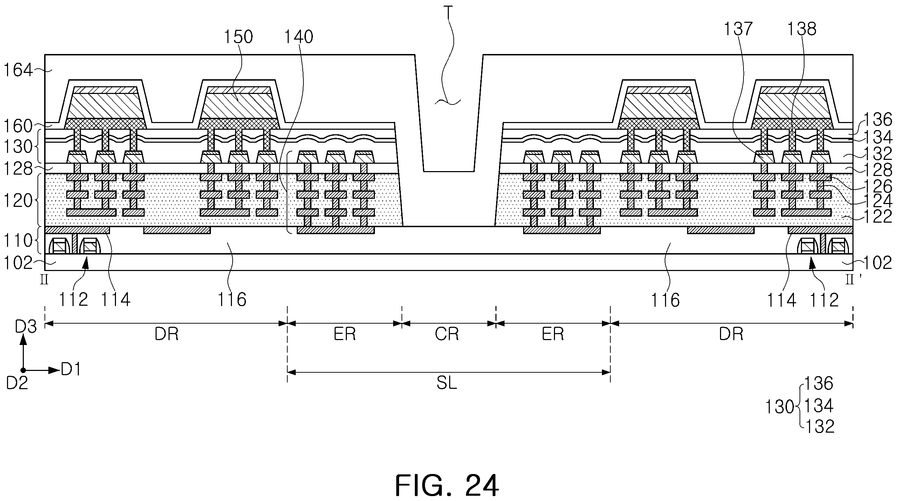

Referring to FIG. 24, a planarization process may be performed, and the first passivation layer 164 may be formed by etching the insulating material layer 164p. The planarization process may include a chemical mechanical polishing (CMP) process. For example, the CMP process may start from an upper portion of the insulating material layer 164p, and the insulating material layer 164p may be etched. Accordingly, the first passivation layer 164 may be formed, and the upper surface of the first passivation layer 164 may be flat.

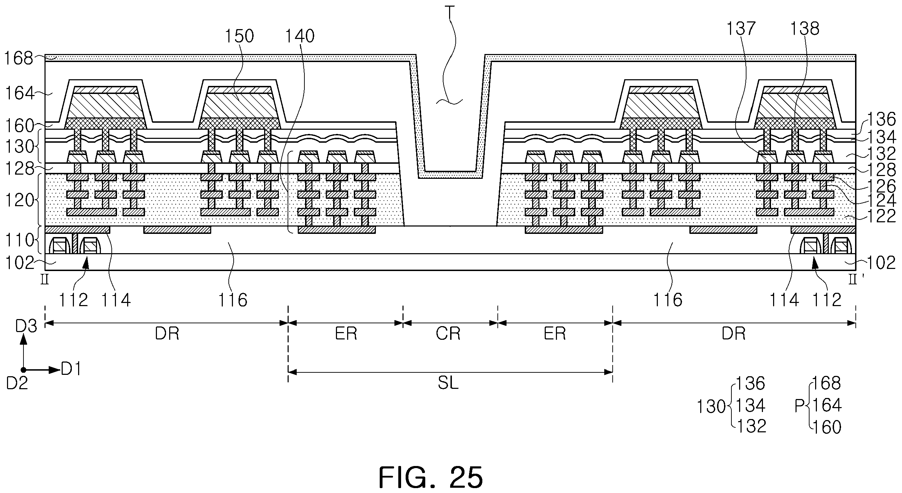

Referring to FIG. 25, a second passivation layer 168 may be formed on the first passivation layer 164. The second passivation layer 168 may be formed conformally along the first passivation layer 164 and the trench T. The protective layer 160, the first passivation layer 164, and the second passivation layer 168 may form a passivation structure P. The passivation structure P may cover an internal wall of the trench T formed along the cutting region CR. The second passivation layer 168 may include silicon nitride, silicon oxynitride, silicon carbonitride, or a combination thereof. For example, the second passivation layer 168 may include silicon nitride.

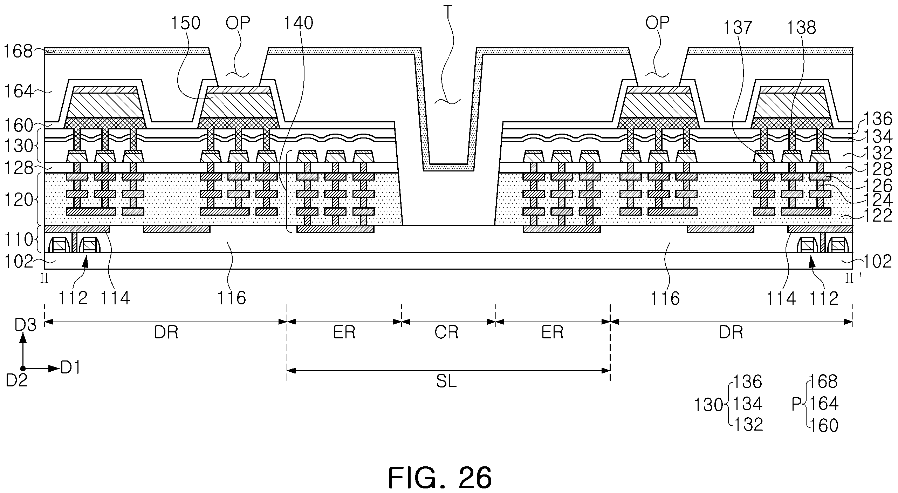

Referring to FIG. 26, an opening OP may be formed by partially etching the protective layer 160, the first passivation layer 164, and the second passivation layer 168. At least one of the upper conductive patterns 150 may be exposed by the opening OP. The term "exposed" may be used to describe relationships between elements and/or certain intermediate processes in fabricating a completed semiconductor device, but may not necessarily require exposure of the particular region, layer, structure or other element in the context of the completed device.

Thereafter, referring to FIGS. 3A and 3B together, the semiconductor substrate 102, the lower interlayer insulating layer 116, the first passivation layer 164, and the second passivation layer 168 may be isolated from each other through a dicing process such that the semiconductor device 100 may be formed. A laser beam may be irradiated to the back side of the semiconductor substrate 102. For example, a thin film tape (not illustrated) may be attached to the semiconductor substrate 102, and a laser beam may be irradiated to a portion of the semiconductor substrate 102 in the cutting region CR. Physical properties of the semiconductor substrate 102 may change at the laser spot to which the laser beam is irradiated, and for example, physical strength of the semiconductor substrate 102 may be weakened. By extending the thin film tape attached to the semiconductor substrate 102 in the horizontal direction, the semiconductor substrate 102 may be separated along the cutting region CR. Alternatively, in example embodiments, the dicing process may include a process of cutting the semiconductor substrate 102 using a sawing wheel.

According to the aforementioned example embodiments, the upper conductive pattern may include a metal layer disposed below the upper metal layer, and the metal layer may be configured to be connected to (or may be integral with) the conductive vias such that the area in which the upper metal layer of the upper conductive pattern is in contact with the metal layer may be widened, and accordingly, resistance of the semiconductor device may be reduced. Also, electro-migration properties of the upper conductive patterns may be improved through or based on a material of the metal layer.

Spatially relative terms such as 'above,' 'upper,' 'higher,' 'below,' 'under,' 'lower,' and the like may be denoted by reference numerals and refer to the drawings, except where otherwise indicated. It will be understood that such spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

While the example embodiments have been illustrated and described above, it will be apparent to those skilled in the art that modifications and variations could be made without departing from the scope of the present disclosure as defined by the appended claims.

## Claims

1. A semiconductor device (100), comprising:
a semiconductor substrate (102);
a device region (110) on the semiconductor substrate (102);
an interconnection region (120) including a lower interconnection (126) on the device region (110);
an insulating structure (130) on the interconnection region (120);
lower conductive patterns (137) in the insulating structure (130);
a first conductive via (129) electrically connecting at least one of the lower conductive patterns (137) to the lower interconnection (126) of the interconnection region (120);
upper conductive patterns (150) on the insulating structure (130); and
second conductive vias (138) in the insulating structure (130) and electrically connecting the upper conductive patterns (150) to the at least one of the lower conductive patterns (137),
wherein the first conductive via (129) comprises a first metal layer (129a) and a first barrier layer (129b) on a lower surface and a side surface of the first metal layer (129a),
wherein the second conductive vias (138) respectively comprise a second metal layer (138a1) in the insulating structure (130) and a second barrier layer (138b1) on a lower surface and a side surface of the second metal layer (138a1), and
wherein the upper conductive patterns (150) respectively comprise:
a third barrier layer (138b2) extending from the second barrier layer (138b1) and on a portion of an upper surface of the insulating structure (130);
a third metal layer (138a2) on the third barrier layer (138b2) and the second metal layer (138a1) and extending from the second metal layer (138a1);
an upper metal layer (150a) on the third metal layer (138a2); and
an upper anti-reflective layer (150b) on the upper metal layer (150a).

2. The semiconductor device (100) of claim 1, wherein a thickness (Duu) of the upper metal layer (150a) is greater than a thickness (Dub) of the third metal layer (138a2) on the upper surface of the insulating structure (130).

3. The semiconductor device (100) of claim 1 or 2,
wherein the insulating structure (130) comprises:
a first upper insulating layer (132) on side surfaces and upper surfaces of the lower conductive patterns (137);
a second upper insulating layer (134) on the first upper insulating layer (132); and
a third upper insulating layer (136) on the second upper insulating layer (134), and
wherein a material of the second upper insulating layer (134) is different from materials of the first and third upper insulating layers (132, 136).

4. The semiconductor device (100c) of any preceding claim, wherein the upper conductive patterns (150) respectively further comprise an upper barrier layer (151) between the upper metal layer (150a) and the third metal layer (138a2).

5. The semiconductor device (100e; 1001) of any preceding claim, further comprising:
an interlayer insulating layer (128) between the interconnection region (120) and the insulating structure (130),
wherein the lower conductive patterns (137) respectively comprise the first barrier layer (129b2) on a portion of an upper surface of the interlayer insulating layer (128), the first metal layer (129a2) on the first barrier layer (129b2) on the portion of the upper surface of the interlayer insulating layer (128), a lower metal layer (137a) on the first metal layer (129a2), and a lower anti-reflective layer (137b) on the lower metal layer (137a).

6. The semiconductor device (100e) of claim 5, wherein a thickness (Dbu) of the lower metal layer (137a) is greater than a thickness (Dbb) of the first metal layer (129a2) on the upper surface of the interlayer insulating layer (128).

7. The semiconductor device (100f) of claim 5, wherein a thickness (Dbu) of the lower metal layer (137a) is substantially equal to or smaller than a thickness (Dbb) of the first metal layer (129a2) on the upper surface of the interlayer insulating layer (128).

8. The semiconductor device (100) of any preceding claim, wherein the upper metal layer (150a) and the second metal layer (138a1) comprise different materials.

9. The semiconductor device (100) of claim 8,
wherein the upper metal layer (150a) comprises aluminum (Al), and
wherein the second metal layer (138a1) includes comprises tungsten (W).

10. The semiconductor device (100) of any preceding claim, wherein respective thicknesses of the upper conductive patterns (150) are greater than respective thicknesses of the lower conductive patterns (137).

11. The semiconductor device (100) of any preceding claim, further comprising:
a protective layer (160) on the insulating structure (130) and the upper conductive patterns (150);
a first passivation layer (164) on the protective layer (160); and
a second passivation layer (168) on the first passivation layer (164).

12. The semiconductor device (100g) of any preceding claim, further comprising:
a via pad (190) below the semiconductor substrate (102) and a through-electrode (170) electrically connected to the via pad (190) and penetrating the semiconductor substrate (102).

13. The semiconductor device (100) of any preceding claim, wherein the upper metal layer (150a) is spaced apart from the upper surface of the insulating structure (130).

14. A semiconductor package (1000), comprising:
a plurality of semiconductor devices (810, 820, 830, 840) stacked sequentially on a buffer chip (805);
adhesive layers (850) between the plurality of semiconductor devices (810, 820, 830, 840); and
an encapsulant (860) on the buffer chip (805) and the plurality of semiconductor devices (810, 820, 830, 840),
wherein the semiconductor devices (810, 820, 830, 840) respectively comprise:
an insulating structure (130) on a semiconductor substrate (102);
a via pad (190) below the semiconductor substrate (102);
a through-electrode (170) electrically connected to the via pad (190) and penetrating the semiconductor substrate (102);
lower conductive patterns (137) in the insulating structure (130);
first conductive vias (129) on lower surfaces of the lower conductive patterns (137);
upper conductive patterns (150) on the insulating structure (130);
second conductive vias (138) in the insulating structure (130) and electrically connecting the upper conductive patterns (150) to at least one of the lower conductive patterns (137); and
a connection pad (195) electrically connected to one of the upper conductive patterns (150),
wherein the first conductive vias (129) respectively comprise a first metal layer (129a) and a first barrier layer (129b) on a lower surface and a side surface of the first metal layer (129a),
wherein the second conductive vias (138) respectively comprise a second metal layer (138a1) in the insulating structure (130) and a second barrier layer (138b1) on a lower surface and a side surface of the second metal layer (138a1), and
wherein the upper conductive patterns (150) respectively comprise:
a third barrier layer (138b2) extending from the second barrier layer (138b1) and on a portion of an upper surface of the insulating structure (130);
a third metal layer (138a2) on the third barrier layer (138b2) and the second metal layer (138a1) and extending from the second metal layer (138a1);
an upper metal layer (150a) on the third metal layer (138a2); and
an upper anti-reflective layer (150b) on the upper metal layer (150a).

15. The semiconductor package (1000) of claim 14, further comprising:
an interlayer insulating layer (128) between the semiconductor substrate (102) and the insulating structure (130),
wherein the lower conductive patterns (137) respectively comprise the first barrier layer (129b2) on a portion of an upper surface of the interlayer insulating layer (128), the first metal layer (129a2) on the first barrier layer (129b2) on the portion of the upper surface of the interlayer insulating layer (128), a lower metal layer (137a) on the first metal layer (129a2), and a lower anti-reflective layer (137b) on the lower metal layer (137a).
